# EUROPEAN PATENT APPLICATION

(11) **EP 2 372 426 A1**
(43) Date of publication of application: **05.10.2011**
(21) Application number: 11153606.6
(22) Date of filing: 07.02.2011
(51) Int. Cl.: G02B 7/02, H01L 33/58

(54) **Optical package-lens bonding method and optical device including lens and optical package**

(30) Priority: 24.03.2010 JP 2010067813
(71) Applicant: Yamatake Corporation, Tokyo 100-6419 (JP)
(72) Inventor: Takahashi, Hidekazu, Tokyo 100-6419 (JP); Mizobuchi, Manabu, Tokyo 100-6419 (JP); Satou, Nagayuki, Tokyo 100-6419 (JP)
(74) Representative: Tomlinson, Kerry John

(57) **Abstract**

There is provided a method of bonding a condensing lens (20) to an optical package (1) containing an optical element (3) therein. The method includes: (a) providing a thermoplastic resin (30,36,38) between a bonding surface (4) of the optical package and a bonding surface (21) of the condensing lens; and (b) adjusting a distance between the bonding surface of the optical package and the bonding surface of the condensing lens by heating the thermoplastic resin to melt the thermoplastic resin while pressing one of the optical package and the lens toward the other or pressing both the optical package and the lens toward each other.

## Description

### Technical Field

The present invention relates to an optical package lens bonding method, and an optical device including a condensing lens and an optical package containing an optical element therein.

### Related Art

Generally, a liquid-state optical adhesive agent is used for bonding a lens to an optical package containing an optical element (*see* e.g., JP-A-2006-339653). Because a simple bonding technique of applying an adhesive agent on a junctional place and pressing a member against the junctional place has a disadvantage in that air bubbles are apt to enter a bonding surface and the adhesive agent per se and are hard to escape therefrom, a centrifugal deaerator, a vacuum deaerator or the like is used for removing air bubbles.

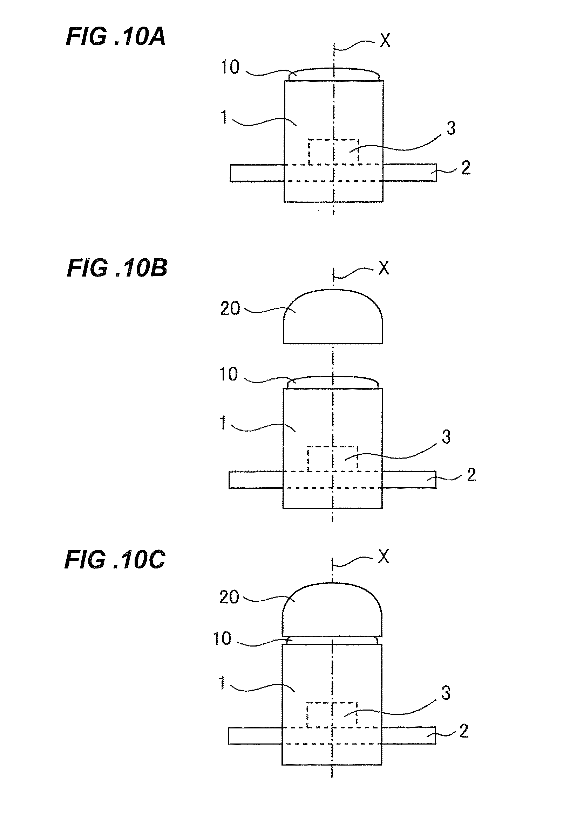

Figs. 10A to 10C show a bonding method in a related-art. In Fig. 10A, an optical element 3 mounted on a board is contained in an optical package 1, and a lead electrode 2 is extended laterally. In this example, the optical package 1 is made of a translucent resin for sealing the optical element 3. First, a liquid-state ultraviolet-curable type optical adhesive agent (hereinafter referred to as adhesive agent) 10 is applied on a top surface of the optical package 1. When the adhesive agent 10 has high viscosity, a deaerating process is performed because air bubbles are hard to escape.

Successively, as shown in Fig. 10B, an optical axis of the optical package 1 and an optical axis of a lens 20 are aligned with each other in terms of optical axis X (represented by a one-dot chain line in Figs 10A to 10C) in a non-contact state. Successively, as shown in Fig. 10C, while the optical axis X of the optical package 1 and the lens 20 is held, the lens 20 is placed on the top surface of the optical package 1 and adjusted with respect to a direction of height thereof and this state is held. When the adhesive agent 10 has high viscosity, a deaerating process is performed here again because air bubbles are hard to escape from a gap between the lens 20 and the optical package 1. Then, the adhesive agent 10 is cured by irradiation with ultraviolet rays, so that the optical package 1 and the lens 20 are bonded to each other.

There is a problem that it is difficult to use the liquid-state adhesive agent 10 heretofore used to adjust the distance between the optical package 1 and the lens 20 because a surface on which the adhesive agent is applied is so thin that the margin for adjustment in the height direction (i.e. the direction of the optical axis) of the optical package 1 and the lens 20 becomes small regardless of whether the adhesive agent has low viscosity or high viscosity. In an optical package to be incorporated into a micro photoelectric sensor or the like, the distance between the optical package and the lens needs to be limited within an allowable range but it is difficult to satisfy this condition because of the aforementioned problem.

### SUMMARY

It is an illustrative aspect of the present invention to provide an optical package-lens bonding method capable of adjusting the distance between an optical package and a lens easily and accurately, and an optical device including a condensing lens and an optical package that are bonded to each other.

According to a first aspect of the present invention, there is provided a method of bonding a condensing lens to an optical package containing an optical element therein. The method includes: (a) providing a thermoplastic resin between a bonding surface of the optical package and a bonding surface of the condensing lens; and (b) adjusting a distance between the bonding surface of the optical package and the bonding surface of the condensing lens by heating the thermoplastic resin to melt the thermoplastic resin while pressing one of the optical package and the lens toward the other or pressing both the optical package and the lens toward each other.

According to a second aspect of the present invention, the method further includes: (c) aligning an optical axis of the optical element and an optical axis of the lens with each other such that the optical package and the thermoplastic resin are brought into contact with each other while the thermoplastic resin and the lens are brought into contact with each other, between steps (a) and (b).

According to a third aspect of the present invention, step (b) is performed such that a surplus of the melted thermoplastic resin is removed from a gap between the bonding surface of the optical package and the bonding surface of the condensing lens.

According to a fourth aspect of the present invention, he thermoplastic resin in a solid state includes: an axial line having both end surfaces that are in contact with the bonding surfaces of the optical package and the lens, respectively; and a plurality of convex portions extending outward from the axial line.

According to a fifth aspect of the present invention, the lens comprises a tapered convex portion that extends from the bonding surface of the lens, and the thermoplastic resin in a solid state comprises a concave portion to be fitted to the convex portion.

According to a sixth aspect of the present invention, an optical device includes: an optical package containing an optical element therein; and a condensing lens bonded to the optical package via a thermoplastic resin. The thermoplastic resin is provided between the optical package and the lens such that a portion of thermoplastic resin surrounds a portion of a side surface of the optical package.

According to the first aspect, it is possible to provide an optical package-lens bonding method capable of adjusting the distance between the optical package and the lens easily and accurately.

According to the second aspect, alignment of optical axes can be performed easily and accurately.

According to the third and fourth aspects, air bubbles in the bonding portion can be reduced.

According to the fifth aspect, when the convex portion and the concave portion are fitted to each other, the optical package and the lens can be aligned with each other easily. Moreover, the melted thermoplastic resin flows out together with air bubbles along the convex shape, so that air bubbles in the junctinal portion can be reduced.

According to the sixth aspect, it is possible to provide an optical package assembly in which adjustment of the distance between the optical package and the lens and alignment of optical axes of the optical package and the lens can be performed easily and accurately in a state where the optical package and the lens are brought into contact with the thermoplastic resin, and in which air bubbles in the respective bonding surfaces between the optical package, the thermoplastic resin and the lens flow out together with the surplus of the thermoplastic resin, so that air bubbles in the bonding portion can be reduced.

### BRIEF DESCRIPTION OF THE DRAWINGS

Fig. 1 is a side view for explaining a method of bonding an optical package and a lens to each other according to Embodiment 1 of the invention and showing a state before bonding;
Fig. 2 is a side view for explaining a method of bonding an optical package and a lens to each other according to Embodiment 1 of the invention and showing a state after bonding;
Fig. 3 is a perspective view showing the external appearance of a thermoplastic resin for bonding the optical package and the lens to each other;
Fig. 4 is a side view for explaining a method of bonding an optical package and a lens to each other according to Embodiment 2 of the invention and showing a state before bonding;
Fig. 5 is a side view for explaining a method of bonding an optical package and a lens to each other according to Embodiment 2 of the invention and showing a state after bonding;
Fig. 6 is a front view of the lens shown in Figs. 4 and 5;
Fig. 7 is a side view for explaining a method of bonding an optical package and a lens to each other according to Embodiment 3 of the invention and showing a state before bonding;
Fig. 8 is a side view for explaining a method of bonding an optical package and a lens to each other according to Embodiment 3 of the invention and showing a state after bonding;
Fig. 9 is a front view of the lens shown in Figs. 7 and 8;
Figs. 10A to 10C are side views for explaining a method of bonding an optical package and a lens to each other in the related art.

### DETAILED DESCRIPTION OF EXEMPLARY EMBODIMENTS

Embodiments of the present invention will be hereinafter described with reference to the drawings.

### Embodiment 1

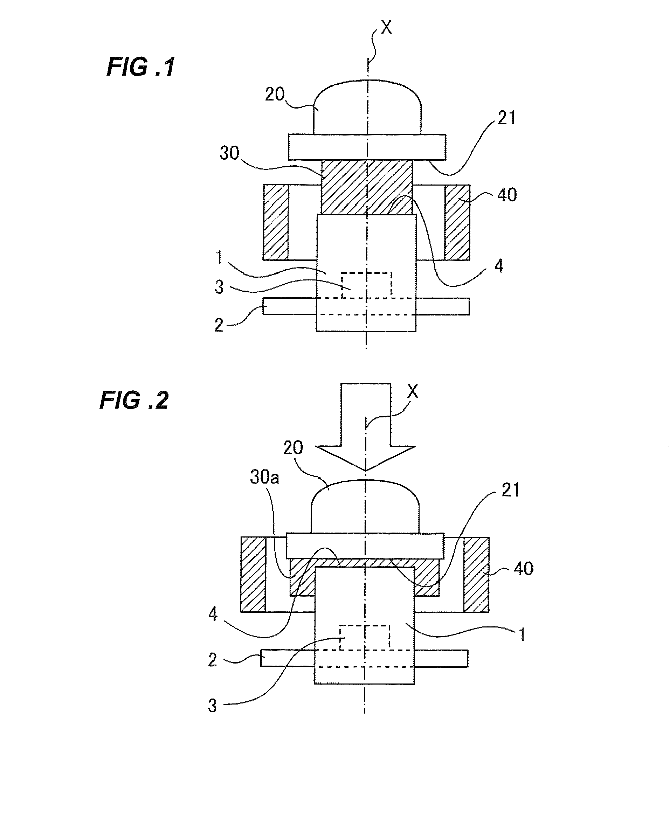

Figs. 1 and 2 are side views for explaining a method pf bonding an optical package 1 and a lens 20 to each other according to Embodiment 1 of the invention. Fig. 1 shows a state before bonding. Fig. 2 shows a state after bonding. In Fig. 1, the optical package 1 contains an optical element 3 mounted on a board and sealed with a translucent resin in the same manner as in the optical package 1 described above with reference to Figs. 10A to 10C. A photo acceptance element, a floodlight element (e.g. light emitting diode) or the like is used as the optical element 3. Incidentally, Figs. 1 and 2 are schematic views showing an instance, so that description of details of wires or the like for connecting the optical element 3 and the board to each other will be omitted. The thermoplastic resin 30, a bonding portion 30a and a heater 40 are shown in sectional view.

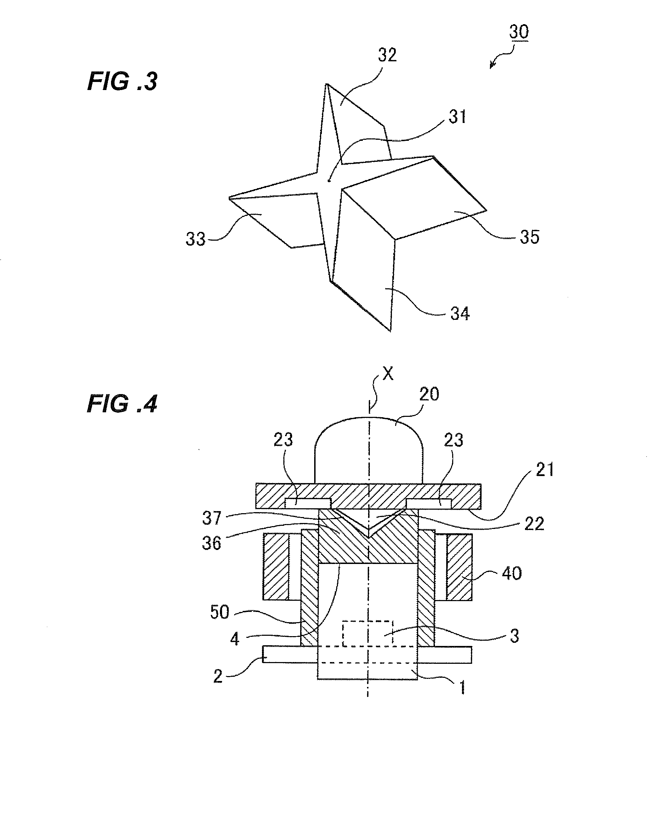

Fig. 3 is a perspective view showing the external appearance of the thermoplastic resin 30 which serves as an adhesive agent for bonding the optical package 1 and the lens 20 to each other. The thermoplastic resin 30 is melted by heat applied on the thermoplastic resin 30 and is solidified again at normal temperature. Incidentally, assume that the melting points or glass transition temperatures of materials of the lens 20 and the optical package 1 are higher than the melting temperature of the thermoplastic resin 30. For example, an acrylic resin (PMMA with a refractive index of 1.49 and a glass transition temperature ranging from minus several degrees to tens of degrees) is used as the thermoplastic resin 30, and polycarbonate (with a refractive index of 1.585 and a melting point of 250 degrees), polyarylate (with a refractive index of 1.61 and a glass transition temperature of 193 degrees) or the like is used as the lens 20. An epoxy resin (thermoplastic resin), a silicone resin or the like is used as the optical package 1.

The shape of the thermoplastic resin 30 has a solid axial line 31, and convex portions 32 to 35 which are formed so as to radiate from the axial line 31. Although Fig. 3 shows an example where the convex portions 32 to 35 cross one another at right angles so that the convex portions 32 to 35 are shaped like a cross in sectional view as a whole, the invention is not limited thereto. For example, three convex portions may be formed at intervals of 120 degrees or convex portions may be shaped like a star in sectional view as a whole. The thermoplastic resin 30 is disposed between a bonding surface 4 of the optical package 1 and a bonding surface 21 of the lens 20 so that opposite end surfaces of the axial line 31 come into contact with the bonding surfaces 4 and 21 respectively.

In Embodiment 1, the thermoplastic resin 30 shown in Fig. 1 is melted and molded into a bonding portion 30a (Fig. 2) for bonding the bonding surfaces 4 and 21 to each other. Although details will be described later, the volume of the thermoplastic resin 30 before melting needs to be larger than the volume of the junctonal portion 30a required for bonding the bonding surfaces 4 and 21 to each other because a part of the thermoplastic resin 30 runs off from a gap between the bonding surfaces 4 and 21.

The bonding method will be described below.
As shown in Fig. 1, an optical axis of the optical element 3 and an optical axis of the lens 20 are aligned with each other in terms of optical axis X (represented by the one-dot chain line in Fig. 1) in a stable state where the thermoplastic resin 30 is disposed between the bonding surface 4 of the optical package 1 and the bonding surface 21 of the lens 20 so that the optical package 1, the thermoplastic resin 30 and the lens 20 come into contact with one another. Because alignment is performed in a contact state, alignment of optical axes can be performed easily and accurately.

On the contrary, in the related art, it was necessary to align optical axes of the optical package 1 and the lens 20 with each other in a non-contact state because a liquid-state adhesive agent was used. For this reason, alignment of optical axes was so unstable that repeat accuracy could not be kept.

Successively, the distance between the bonding surfaces 4 and 21 is adjusted in such a manner that the lens 20 is pressed toward the optical package 1 while the thermoplastic resin 30 is heated by the heater 40 so as to be melted. For this reason, the distance can be adjusted easily and accurately. When the lens 20 is pressed, the melted thermoplastic resin 30 is pressed so as to radiate from its center, so that a surplus of the thermoplastic resin 30 flows out from a gap between the bonding surfaces 4 and 21. At the same time, four spaces (air layers) separated by the four convex portions 32 to 35 flow out from the center, so that air bubbles in bonded portions between the thermoplastic resin 30 and the bonding surfaces 4 and 21 can be reduced. Moreover, because the area of contact between the thermoplastic resin 30 before melting and the bonding surface 4 or 21 is small, air bubbles present between the thermoplastic resin 30 and the bonding surface 4 or 21 can be reduced. Because air bubbles can be suppressed, the deaerating process required in the background art can be dispensed with.

On the contrary, in the background art, since a liquid-state adhesive agent was used, the margin for adjustment of the distance between the optical package 1 and the lens 20 was so small that it was difficult to adjust the distance. Moreover, when the adhesive agent had high viscosity, air bubbles were apt to be generated and were hard to escape. When the adhesive agent had low viscosity, the surface on which the adhesive agent was applied was particularly so thin that air bubbles were hard to escape from the gap between the optical package 1 and the lens 20. For this reason, when, for example, the optical package 1 integrated with the lens 20 by the aforementioned bonding method according to the background art was used for a photoelectric sensor, expected optical characteristic of the lens 20 was spoiled by the air bubbles so that there was a possibility that the air bubbles would be a barrier to long-range applicability and high sensitivity of the photoelectric sensor.

Successively, the state of Fig. 2 is held until the temperature of the thermoplastic resin 30 reaches normal temperature, so that the thermoplastic resin 30 is molded into a shape of the bonding portion 30a to bond the optical package 1 and the lens 20 to each other through the bonding portion 30a.
Incidentally, a ring-shaped heater, a jacket heater, a rubber heater or the like may be used as the heater 40. The temperature of the heater is controlled so as to be lower than an upper limit of the storage temperature of the optical package 1. Although this embodiment shows the case where the lens 20 is pressed toward the optical package 1, the invention is not limited thereto. For example, the optical package 1 may be pressed toward the lens 20 or the optical package 1 and the lens 20 may be pressed toward each other.

As described above, according to Embodiment 1, provided is a bonding method for bonding a condensing lens 20 to an optical package 1 containing an optical element 3 to integrate the lens 20 with the optical package 1, the method including the steps of: disposing a thermoplastic resin 30 between a bonding surface 4 of the optical package 1 and a bonding surface 21 of the lens 20 and aligning optical axes X of the optical element 3 and the lens 20 with each other in a state where the optical package 1 and the thermoplastic resin 30 are brought into contact with each other while the thermoplastic resin 30 and the lens 20 are brought into contact with each other; discharging a surplus of the thermoplastic resin 30 from a gap between the bonding surfaces 4 and 21 while adjusting the distance between the bonding surfaces 4 and 21 in such a manner that the thermoplastic resin 30 is heated by a heater 40 so as to be melted while the lens 20 is pressed toward the optical package 1; and molding the thermoplastic resin 30 into a bonding portion 30a while holding this state to thereby bond the optical package 1 and the lens 20 to each other. Accordingly, because the thermoplastic resin 30 has a height, the distance between the bonding surfaces 4 and 21 can be adjusted easily and accurately in such a manner that the lens 20 is pressed while the height is adjusted when the thermoplastic resin 30 is heated. Moreover, optical axes X of the optical element 3 and the lens 20 can be aligned with each other easily and accurately in a stable state where the bonding surfaces 4 and 21 are brought into contact with the thermoplastic resin 30.

According to Embodiment 1, configuration is made in such a manner that the thermoplastic resin 30 which has not been melted yet has an axial line 31 disposed in parallel to a direction between the bonding surface 4 of the optical package 1 and the bonding surface 21 of the lens 20, and convex portions 32 to 35 formed so as to radiate from the axial line 31. Accordingly, the area of contact of the thermoplastic resin 30 with the bonding surfaces 4 and 21 can be reduced so that air bubbles present in the respective bonding surfaces between the optical package 1, the thermoplastic resin 30 and the lens 20 can be reduced. Because the thermoplastic resin 30 radiates from the axial line 31 so as to flow out together with air bubbles when the thermoplastic resin 30 is melted, air bubbles in the bonding portion can be reduced.

### Embodiment 2

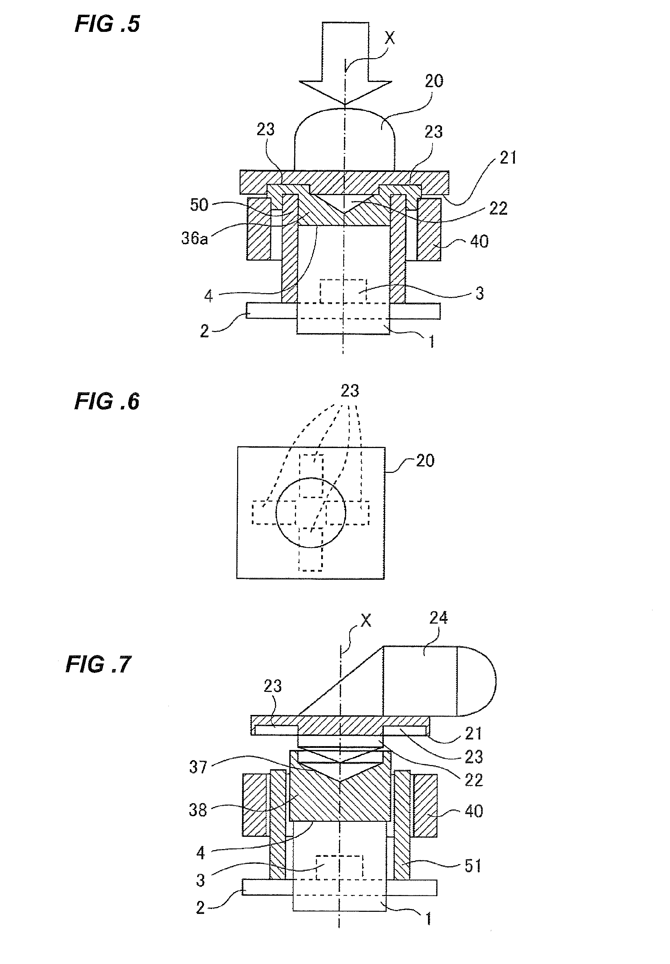

Figs. 4 and 5 are side views for explaining a method of bonding an optical package 1 and a lens 20 according to Embodiment 2 of the invention. Fig. 4 shows a state before bonding. Fig. 5 shows a state after bonding. Fig. 6 is a front view of the lens 20. Incidentally, in Figs. 4 to 6, parts the same as or equivalent to those in Figs. 1 and 2 are referred to by the same numerals and description thereof will be omitted. A part of the lens 20, a thermoplastic resin 36, a bonding portion 36a, a heater 40 and a spacer 50 are shown in sectional view.

In Embodiment 2, a tapered convex shape 22 protruding toward the thermoplastic resin 36 is formed in the bonding surface 21 of the lens 20, and grooves are provided around the convex shape 22 so that the grooves serve as resin receiving portions 23 into which the melted resin flows.

The thermoplastic resin 36 is shaped like a solid cylinder having substantially the same outer diameter as that of the optical package 1, and a concave shape 37 is formed in a top surface of the cylinder facing the lens 20 so that the concave shape 37 is fitted to the contour of the convex shape 22. In the example shown in Figs. 4 to 6, while the convex shape 22 as a conical shape is formed in the lens 20 so that an apex of the cone is made coincident with the optical axis X of the lens 20, the concave shape 37 as a conically concave shape cut in accordance with the conical shape of the convex shape 22 is formed in the thermoplastic resin 36 so that an apex of the cone is made coincident with the optical axis X of the optical element 3.

The spacer 50 has an inner diameter substantially the same as the outer diameter of the optical package 1. The distance between the optical package 1 and the lens 20 is defined based on the height of the spacer 50. That is, the bonding surface 21 of the lens 20 pressed to move abuts on the top surface of the spacer 50 to thereby limit movement of the lens 20.

The bonding method will be described below.
As shown in Fig. 4, the thermoplastic resin 36 is disposed between the bonding surface 4 of the optical package 1 and the bonding surface 21 of the lens 20. On this occasion, the optical package 1 and the thermoplastic resin 36 are aligned with each other by the spacer 50 so that the apex of the concave shape 37 coincides with the optical axis X of the optical element 3 located in the center of the optical package 1. Moreover, the convex shape 22 and the concave shape 37 are fitted to each other to thereby align the lens 20 and the thermoplastic resin 36 with each other so that the apex of the convex shape 22 coincides with the optical axis X of the lens 20. Accordingly, the optical axes of the optical element 3 and the lens 20 can be aligned with each other.

Successively, the distance between the bonding surfaces 4 and 21 is adjusted automatically in such a manner that the lens 20 is pressed toward the optical package 1 so that the bonding surface 21 is pressed against the top surface of the spacer 50 while the thermoplastic resin 36 is heated by the heater 40 so as to be melted. That is, as shown in Fig. 6, a part of the bonding surface 21 without the resin receiving portions 23 abuts on the top surface (not shown) of the spacer 50 so that the bonding surface 21 is held at the height. When the lens 20 is pressed, the melted thermoplastic resin 36 moves up along the V-shaped surface of the convex shape 22, so that a surplus of the thermoplastic resin 36 flows out from a gap between the bonding surfaces 4 and 21 to the resin receiving portions 23. In this manner, the thermoplastic resin 36 is molded into the shape of the bonding portion 36a (Fig. 5) so that the optical package 1 and the lens 20 are bonded to each other through the bonding portion 36a.

As described above, according to Embodiment 2, configuration is made in such a manner that the bonding surface 21 of the lens 20 has a tapered convex shape 22 protruding from the bonding surface 21 whereas the thermoplastic resin 36 which has not been melted yet has a concave shape 37 to be fitted to the convex shape 22 of the bonding surface 21 of the lens 20. Accordingly, when the convex shape and the concave shape 37 are fitted to each other, the optical package 1 and the lens 20 can be aligned with each other easily. Moreover, because the melted thermoplastic resin 36 flows out together with air bubbles along the convex shape 22 from the gap between the bonding surfaces 4 and 21, air bubbles in the bonding portion can be reduced.

According to Embodiment 2, configuration is made in such a manner that the spacer 50 is provided so as to abut on the bonding surface 21 of the lens 20 pressed to move to thereby limit movement of the lens 20 to adjust the distance between the bonding surfaces 4 and 21. Accordingly, the distance between the bonding surfaces 4 and 21 can be adjusted easily.

### Embodiment 3

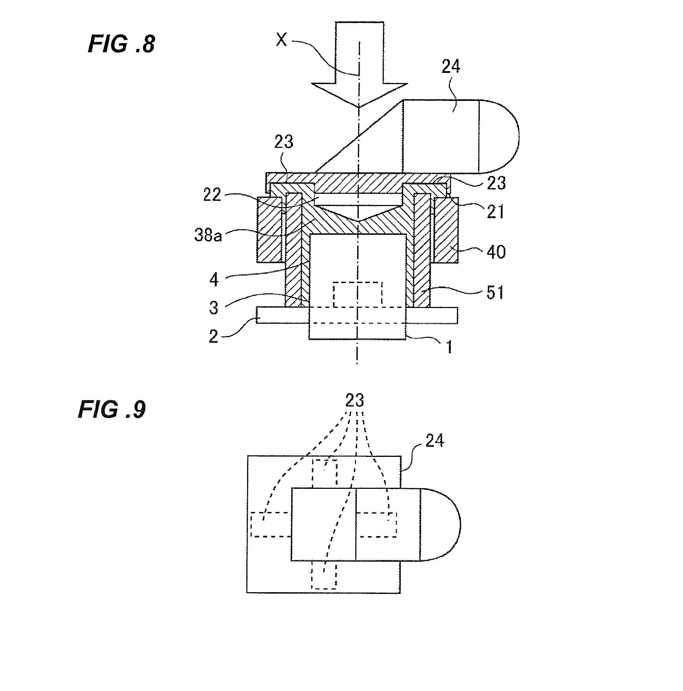

Figs. 7 and 8 are side views for explaining a method of bonding an optical package 1 and a prism lens 24 according to Embodiment 3 of the invention. Fig. 7 shows a state before bonding. Fig. 8 shows a state after bonding. Fig. 9 is a front view of the prism lens 24. Incidentally, in Figs. 7 to 9, parts the same as or equivalent to those in Figs. 1 to 6 are referred to by the same numerals and description thereof will be omitted. A part of the prism lens 24, a thermoplastic resin 38, a bonding portion 38a, a heater 40 and a spacer 51 are shown in sectional view.

In Embodiment 3, in the same manner as in Embodiment 2, a tapered convex shape 22 protruding toward the thermoplastic resin 38 is formed in the bonding surface 21 of the prism lens 24 whereas grooves are provided around the convex shape 22 so that the grooves serve as resin receiving portions 23 into which the melted resin flows.

The thermoplastic resin 38 is shaped like a solid cylinder having an outer diameter larger than the outer diameter of the optical package 1, and a concave shape 37 having a contour slightly larger than the contour of the convex shape 22 is formed in a top surface of the cylinder facing the prism lens 24 so that the concave shape 37 is fitted to the convex shape 22. In the example shown in Figs. 7 to 9, while the convex shape 22 as a substantially conical shape is formed in the prism lens 24 so that an apex of the substantially conical shape is made coincident with the optical axis X of the prism lens 24, the concave shape 37 as a conically concave shape cut so largely as to be fitted to the substantially conical shape of the convex shape 22 is formed in the thermoplastic resin 38.

The spacer 51 has an inner diameter large than the outer diameter of the optical package 1 and the outer diameter of the thermoplastic resin 38. The distance between the optical package 1 and the prism lens 24 is defined based on the height of the spacer 51.

The bonding method will be described below.
As shown in Fig. 7, the thermoplastic resin 38 is disposed between the bonding surface 4 of the optical package 1 and the bonding surface 21 of the prism lens 24. On this occasion, the apex of the concave shape 37 of the thermoplastic resin 38 and the optical axis X of the optical element 3 are aligned with each other in a stable state where the thermoplastic resin 38 and the optical package 1 are brought into contact with each other. Moreover, the convex shape 22 and the concave shape 37 are fitted to each other to thereby align the prism lens 24 and the thermoplastic resin 38 with each other so that the apex of the convex shape 22 coincides with the optical axis X of the prism lens 24. Accordingly, the optical element 3 and the prism lens 24 can be aligned with each other.

Successively, the distance between the bonding surfaces 4 and 21 is adjusted automatically in such a manner that the prism lens 24 is pressed toward the optical package 1 so that the bonding surface 21 is pressed against the top surface of the spacer 51 while the thermoplastic resin 38 is heated by the heater 40 so as to be melted. That is, as shown in Fig. 9, a part of the bonding surface 21 without the resin receiving portions 23 abuts on the top surface (not shown) of the spacer 51 so that the bonding surface 21 is held at the height. When the prism lens 24 is pressed, the melted thermoplastic resin 38 moves up along the V-shaped surface of the convex shape 22, so that a surplus of the thermoplastic resin 38 flows out from a gap between the bonding surfaces 4 and 21 to the resin receiving portions 23. In this manner, the thermoplastic resin 38 is molded into the shape of the bonding portion 38a (Fig. 8) so that the optical package 1 and the prism lens 24 are bonded to each other through the bonding portion 38a.

As described above, according to Embodiment 3, configuration is made in such a manner that the bonding surface 21 of the prism lens 24 has a tapered convex shape 22 protruding from the bonding surface 21 whereas the thermoplastic resin 38 which has not been melted yet has a concave shape 37 to be fitted to the convex shape 22 of the bonding surface 21 of the prism lens 24. Accordingly, when the convex shape 22 and the concave shape 37 are fitted to each other, the optical package 1 and the prism lens 24 can be aligned with each other easily in order to be bonded to each other. Moreover, because the melted thermoplastic resin 38 flows out together with air bubbles along the convex shape 22 from the gap between the bonding surfaces 4 and 21, air bubbles in the bonding portion can be reduced.

## Claims

1. A method of bonding a condensing lens (20) to an optical package (1) containing an optical element (3) therein, the method comprising:
(a) providing a thermoplastic resin (30,36,38) between a bonding surface (4) of the optical package and a bonding surface (21) of the condensing lens; and
(b) adjusting a distance between the bonding surface of the optical package and the bonding surface of the condensing lens by heating the thermoplastic resin to melt the thermoplastic resin while pressing one of the optical package and the lens toward the other or pressing both the optical package and the lens toward each other.

2. The method of Claim **1**, further comprising:
(c) aligning an optical axis of the optical element and an optical axis of the lens with each other such that the optical package and the thermoplastic resin are brought into contact with each other while the thermoplastic resin and the lens are brought into contact with each other, between steps (a) and (b).

3. The method of Claim **1**, wherein step (b) is performed such that a surplus of the melted thermoplastic resin is removed from a gap between the bonding surface of the optical package and the bonding surface of the condensing lens.

4. The method of any one of Claims **1** to **3**,
wherein the thermoplastic resin in a solid state comprises:
an axial line (31) having both end surfaces that are in contact with the bonding surfaces of the optical package and the lens, respectively; and
a plurality of convex portions (32,33,34,35) extending outward from the axial line.

5. The method of any one of Claims **1** to **4**, wherein
the lens comprises a tapered convex portion (22) that extends from the bonding surface of the lens, and
the thermoplastic resin in a solid state comprises a concave portion (37) to be fitted to the convex portion.

6. An optical device comprising:
an optical package (1) containing an optical element (3) therein; and
a condensing lens (20) bonded to the optical package (1) via a thermoplastic resin (30,36,38),
wherein the thermoplastic resin is provided between the optical package and the lens such that a portion of thermoplastic resin surrounds a portion of a side surface of the optical package.
